# EUROPEAN PATENT APPLICATION

(11) **EP 2 012 427 A2**
(43) Date of publication of application: **07.01.2009**
(21) Application number: 08159459.0
(22) Date of filing: 01.07.2008
(51) Int. Cl.: H03H 9/21

(54) **Piezoelectric vibrating pieces and piezoelectric devices**

(30) Priority: 02.07.2007 JP 2007173863
(71) Applicant: Nihon Dempa Kogyo Co., Ltd., Shibuya-ku Tokyo 151-8569 (JP)
(72) Inventor: Kawanishi, Shingo c/o Nihon Dempa Kogyo Co., Ltd., Saitama (JP); Iwai, Yu c/o Nihon Dempa Kogyo Co., Ltd., Saitama (JP); Ichikawa, Ryoichi c/o Nihon Dempa Kogyo Co., Ltd., Saitama (JP)
(74) Representative: Zimmermann & Partner

(57) **Abstract**

The piezoelectric vibrating piece (20) comprises a base portion (29) having an adhesive area on a first surface of electrically conductive adhesive 31 for mounting, a pair of vibrating arms (21) extending in a first direction from one edge of the base portion, base electrodes (23a, 25a) arranged in the base portion, an exciting electrode (23c, 25c) extending in a first direction and connecting the base electrode to excite a pair of vibrating arms. The area where the base electrodes (23a, 25a) contact the electrically conductive adhesive (31) is smaller than the adhesive area (33).

## Description

### FIELD OF THE INVENTION

The present invention relates to improvement of a piezoelectric vibrating piece and a piezoelectric device accommodating the piezoelectric vibrating piece inside of the package.

### DESCRIPTION OF THE RELATED ART

For small information device, such as HDD (Hard Disc Drive), mobile computers, or IC cards, or clock sources of mobile phones, piezoelectric devices such as a piezoelectric vibrating piece or a piezoelectric oscillator is being used.

A tuning-fork type piezoelectric vibrating piece disclosed in Japan Unexamined Patent Application No. 2001-203560 is formed the tuning-fork type outer shape by wet etching a piezoelectric material such as a crystal wafer. In order to lower crystal impedance (CI) value of the tuning-fork type piezoelectric vibrating piece, the relation of width and thickness of pair of vibrating arms is adjusted. Japan Unexamined Patent Application No. 2004-266871 discloses that for stabilizing the CI value variability and miniaturizing of the tuning-fork type piezoelectric vibrating piece, groove portions on the pair of arms and a notch on the base portion are formed to lower the CI value variability between each element.

However, as disclosed in Japan Unexamined Patent Application No. 2004-266871, even the tuning-fork type piezoelectric vibrating piece having a notch on the base portion has large variability of CI value, and even compared to a tuning-fork type piezoelectric vibrating piece without having a notch, the variability of CI value is not improved. Also, tuning-fork type piezoelectric vibrating pieces having great value of a variability (of temperature characteristic) of zero temperature coefficient (ZTC), which are under standard at a quality check, are manufactured a lot.

The present invention, therefore, is made to solve foregoing problems. The purpose of the present invention is to provide a piezoelectric vibrating piece or piezoelectric device having improved variability of CI value and also of ZTC for miniaturization. However, in some examples, other featured and advantages are realized, and other problems may be solved.

### SUMMARY

A piezoelectric vibrating piece comprised of a piezoelectric material having a first and second surface, comprising a base portion having an adhesive area of electrically conductive adhesive on the first surface for mounting, at least a pair of vibrating arms extended in a first direction from one end of the base portion, a base electrode arranged on the base portion; and an exciting electrode extended in a first direction connecting the base electrode to excite the pair of vibrating arms, wherein an area of the base electrode which to contact the electrically conductive adhesive is smaller than a dimension of the adhesive area.

According to the configuration of first aspect, even if a piezoelectric vibrating piece is attached without changing the amount of the electrically conductive adhesive to be applied, an area where the base electrode contacts the electrically conductive adhesive is smaller than the adhesive area. With such a configuration, the variability of CI value as well as of ZTC becomes lower. Thus, the ratio of defective product are decreased when they are checked their CI value or ZTC.

The piezoelectric vibrating piece of second aspect is that the width of the base electrode is narrower than the width of the exciting electrode in second direction intersecting with the one in the first direction.
According to the configuration of the second aspect, by making the width of the base electrode than of exciting electrode narrow, the area to be contacted with the electrically conductive adhesive can be small.

The base electrode of piezoelectric vibrating piece of third aspect is extended to only the middle of another end from the one end of the base portion.
According to the configuration of the third aspect, by making the width of base electrode extended from the exciting electrode shorter than the exciting electrode, the area to be contacted with the electrically conductive adhesive can be small.

The piezoelectric vibrating piece of the forth aspect is that the dimension of the base electrode on the first surface and the one on the second surface is different.
It is the best if one surface of the base electrode, where the electrically conductive adhesive to be applied, is smaller than the dimension of the adhesive area. The other side can be the base electrode as same big size as previous one. Generally the base electrode is manufactured through a photolithography process. The other surface can use the previous mask used in the photolithography process.

The base electrode of piezoelectric vibrating piece of the fifth aspect is comprised of a first base electrode and a second base electrode, the adhesive area of the electrically conductive adhesive is comprised of a first adhesive area corresponding the first base electrode and a second adhesive area corresponding the second base electrode, and the area contacting the first base electrode is smaller than the dimension of the first adhesive area and the area contacting the second base electrode is smaller than the dimension of the second adhesive area. According to the configuration of the fifth aspect, because the area that the first base electrode contacts is a smaller than the dimension of the first adhesive area and the area that the second base electrode contacts is smaller than the dimension of the second adhesive area, the CI value variability and ZTC variability are stable when it is compared to the result from the only one base electrode having smaller dimension than the adhesive area.

The piezoelectric vibrating piece of the sixth aspect is that due to an insulting layer formed on the surface of the base electrode, the area contacting the base electrode contacting an electrically conductive adhesive is smaller than the dimension of the adhesive area. By forming insulating layer after a large base electrode is formed by a mask previously used in a photolithography method, it can make the base electrode smaller than the dimension of adhesive area the electrically conductive adhesive contact.

The piezoelectric vibrating piece of the seventh aspect has the area where the base electrode contacts the electrically conductive adhesive is 1% to 80% of dimension of the adhesive area. According to the configuration of the seventh aspect, if the contacting area is more than 1%, it can actually excite the piezoelectric vibrating piece. On the other hand, if the contacting area is more than 80%, the difference becomes smaller when it is compared to the base electrode being larger than the adhesive area of the electrically conductive adhesive.

The piezoelectric device of the eighth aspect comprises the piezoelectric vibrating piece of any of the first to seventh aspects, a package containing the piezoelectric vibrating piece, and a cap sealing the package. According to the configuration of eighth aspect, by using a piezoelectric vibrating piece of which CI value variability is small and ZTC variability is improved, a piezoelectric device can be provided. Therefore, less defective products are manufactured and it outputs stable and accurate vibrational frequency as a clock source for information device such as mobile phones.

The present invention provides a piezoelectric vibrating piece and piezoelectric device in which the CI value variability is typically but not necessarily lowered and also the ZTC variability is generally, but not necessarily improved.

### BRIEF DESCRIPTION OF THE DRAWINGS

FIG. 1A is a flat view of the tuning-fork type crystal vibrating piece 20 of the present invention.
FIG. 1B is a cross-sectional view of the vibrating arm 21 taken from B-B line.
FIG. 2 is an enlarged view of the tuning-fork type crystal vibrating piece 20 shown in FIG. 1.
FIGS. 3A-3B show a piezoelectric device 50 mounting the tuning-fork type crystal vibrating piece 20 on the package 51. FIG. 3A is a top view the metal cap 56 is removed. FIG. 3B is a cross-sectional view taken from B-B line and the metal cap 56 is attached.
FIG. 4A is an enlarged view of the base portion 29 of the tuning-fork type crystal vibrating piece 20 of the second embodiment.
FIG. 4B is an cross-sectional view taken from B-B line of the FIG. 4A.
FIG. 5A is an enlarged view of the base portion 29 of the tuning-fork type crystal vibrating piece 20 of the third embodiment.
FIG. 5B is an enlarged view of the base portion 29 of the tuning-fork type crystal vibrating piece 20 of the forth embodiment.
FIGS. 6A-6B are enlarged views showing the second base portion 29-2 of the fifth embodiment. FIG. 6A shows a back surface (a surface to be adhered) of the second base portion 29-2 of the fifth embodiment. FIG. 6B shows a front surface, and FIG. 6C is a cross-sectional view taken from C-C line of FIG. 6B.
FIGS. 7A-7B are enlarged views showing the second base portion 29-2 of the sixth embodiment. FIG. 7A shows a back surface of the second base portion 29-2 of the sixth embodiment, and FIG. 7B is a cross-sectional view taken from B-B line of FIG. 7A.
FIG. 8A illustrates a conventional tuning-fork type crystal vibrating piece and two embodiments of tuning-fork type crystal vibrating pieces according to the present disclosure.
FIGS. 8B-8C are graphs showing the research result of ratio and variability of base electrode dimension to the electrically conductive adhesive regarding CI value and ZTC.
FIG. 9 is a plan view of showing the embodiment of the second tuning-fork type crystal vibrating piece 120 of present invention.
FIG. 10A shows the tuning-fork type crystal oscillator 60.
FIG. 10B is a schematic view of the cylinder type tuning-fork vibrator 70.

### DETAILED DESCRIPTION

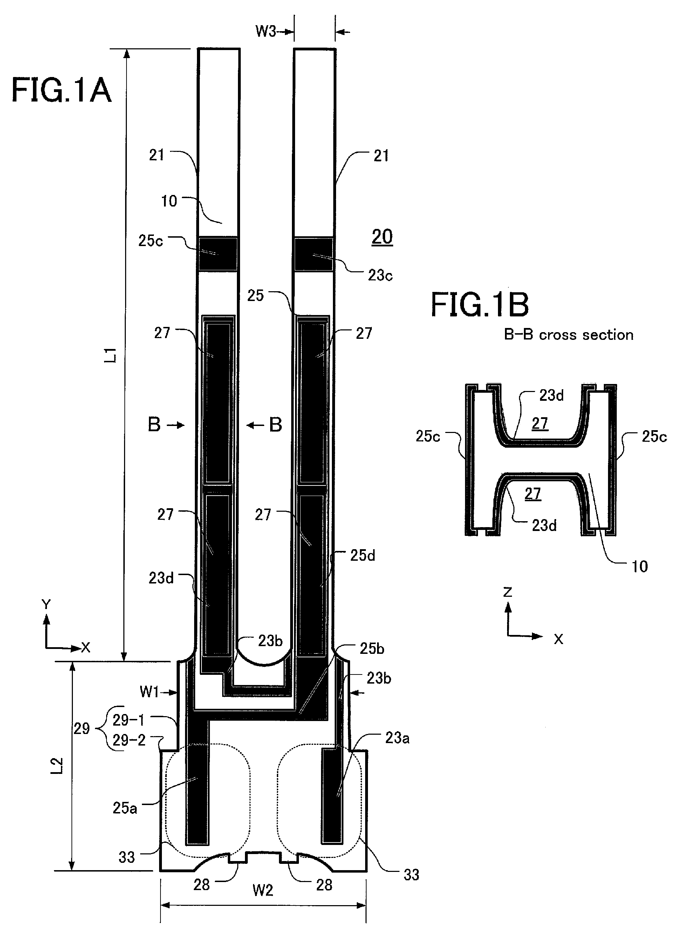

FIG. 1A is a flat view showing an embodiment of a tuning-fork type crystals vibrating piece 20 of the present invention. FIG.1B is a cross-sectional view taken from B-B line. The tuning-fork type piezoelectric vibrating piece 20 is formed by cutting a single crystal as it is like a crystal Z board 10. Besides a crystal, a piezoelectric material such as lithium tantalite or lithium niobate can be used. Also, the tuning-fork type crystal vibrating piece 20 showed in FIGS. 1A-1B is a small vibrating piece oscillates a signal with 32.768kH. Such a tuning-fork type crystal vibrating piece 20 has a base portion 29 and a pair of vibrating arms 21 which is extended from the base portion 29 in X direction. On the surface of the pair of arms 21, two of groove portions 27 are formed on each arm 21 as shown in FIGS. 1A-1B. The groove portions 27 are formed as well as on the back surface of the pair of arms 21, as shown in FIG.1B, a cross-sectional view of the groove portion 27 of the pair of arms 21 is nearly H-shape. The groove portion 27 is formed to control a rise of the CI value.

As shown in FIG. 1A, the entire portion of the base portion 29 of tuning-fork type crystal vibrating piece 20 is formed nearly a board-shape. Also a length L2 in a longitudinal direction is formed, for example, 0.58mm. On the other hand, a length L1 in a longitudinal direction of the pair of arm 21 extended from the base portion 20 is formed about 1.70mm. Therefore, the length of base portion 29 corresponding pair of arms 21 is about 34%. Also, a width W3 of the pair of arms 21 is about 0.12mm.

The base portion 29 has a first base portion 29-1 on the side of the pair of arms 21 and a second base portion 29-2 on the side of an adhesive area 33. The width in X direction of the first base portion 29-1 is a width W1 and the width in X direction of the second base portion 29-2 is a width W2 which is wider than the width W1. The width W1 is 75% to 90% of the width W2. For example, the width W1 is 0.42mm and width W2 is 0.55mm. So, vibration from vibration of the arms 21 leaked through the groove portion 27 is not easily transmitted to the second base portion 29-2.

Also, on the second base portion 29-2, two of connecting portions 28 are formed. The two of connecting portions 28 are a remaining material when the tuning-fork type crystal vibrating piece 20 is cut from the single crystal wafer, and generally thousands of tuning-fork type crystal vibrating pieces 20 is connected to a board of single crystal wafer.

On the pair of arms 21 and base portion 29 of the tuning-fork type crystal vibrating piece 20, a first electrode pattern 23 and a second electrode pattern 25 are formed. Both of the first electrode pattern 23 and the second electrode pattern 25 have a configuration of a gold (Au) layer of 400 to 3000 angstroms formed on a chrome (Cr) layer of 50 to 700 angstroms. Instead of the chrome (Cr) layer, a tungsten (W) layer or a titanium (Ti) layer can be used, and instead of the gold (Au) layer, a silver (Ag) layer also can be used. The layer can be formed with one layer and an aluminum (Al) layer can be used for it.

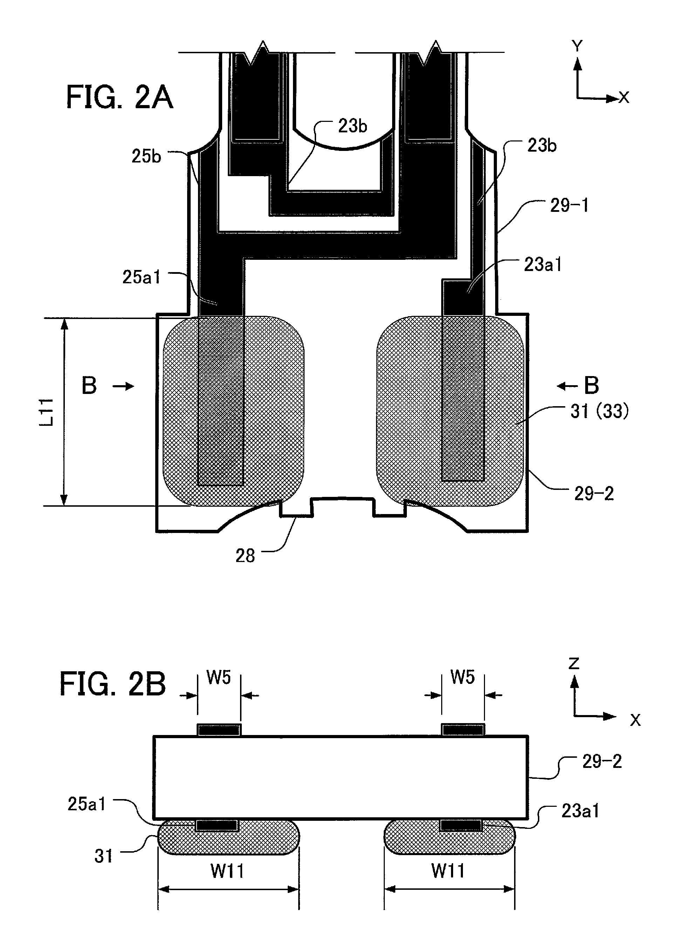

On the base portion 29 of the tuning-fork type crystal vibrating piece 20, a first base electrode 23a1 and a second base electrode 25a1 are formed, and on the groove portion 27 of the pair of arms 27, a first groove electrode 23d and a second groove electrode 25d are formed. The widths of the first groove electrode 23d and the second groove electrode 24d are the same width of a width W3 of the pair of arms 21. As FIG. 1B shown, on the both surfaces of the left vibrating arm 21, second electrodes 25c are formed. On the both surfaces of the right vibrating arm 21, first electrodes 23c are formed. A first connecting electrode 23b is formed to contact the first base electrode 23a1, a first side surface electrode 23c, and the first groove electrode 23d, and a second connecting electrode 25b is formed to contact a second base electrode 25a1, a second side surface electrode 25c, and the second groove electrode 25d. Electrically conductive adhesive 31 (see FIG. 2) is applied to the adhesive area 33 of the first base electrode 23a1 and the second base electrode 25a1.

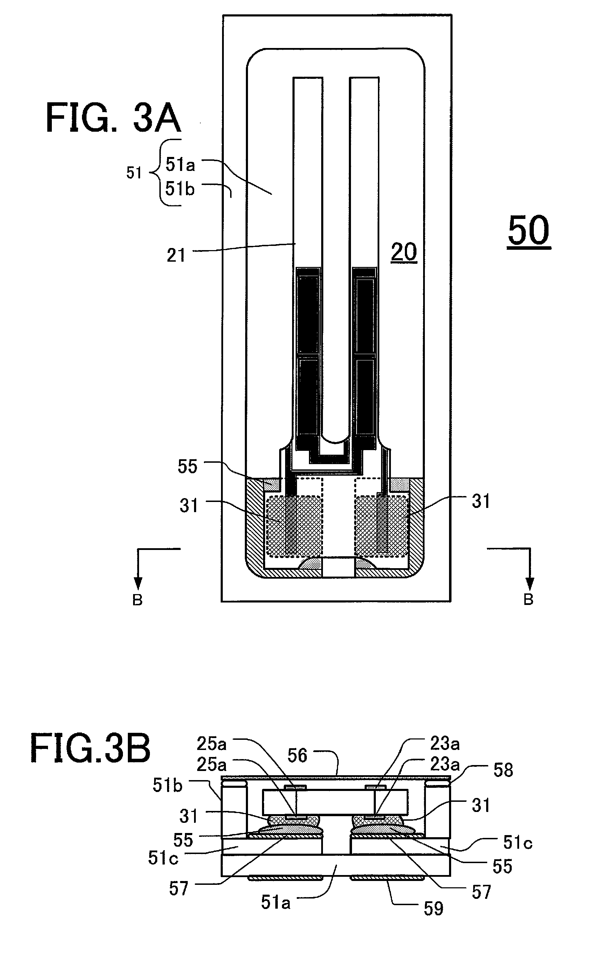

FIG. 2A is an enlarged view of the base portion 29 on the tuning-fork type crystal vibrating piece 20 shown in FIGS. 1A-1B. FIG. 2B is a cross-sectional view taken from B-B line of FIG. 2A. The first base electrode 23a1 and the second base electrode 25a is extended to the end direction (Y direction) of the second base portion and the width of an electrode width W5 is formed narrowly with 0.01mm to 0.10mm. Then, the electrically conductive adhesive 31 is applied from a needle which is not illustrated to a connecting electrode (see FIGS. 3A-3B). In order to distinguish an applied area of electrically conductive adhesive 31 and the size of the first base electrode 23a1 and the second base electrode 25a1, it is illustrated as the electrically conductive adhesive 31 is applied on the first base electrode 23a1 and the second base electrode 25a1.

The electrically conductive adhesive 31 is comprised of epoxy, silicone, polyimide or polyurethane resin as a binder, and conductive filler such as silver, nickel, or carbon. The electrically conductive adhesive 31 is applied on the adhesive area to prevent the tuning fork-type crystal vibrating piece 20 to come off by impact. The adhesive area of the electrically conductive adhesive 31 has a length L11 is, for example, about 0.3mm and a width W11 is 0.15 to 0.20mm. If the size of adhesive area is smaller than this, the tuning fork-type crystal vibrating piece 20 may be come off by impact.

The dimensions of the first base electrode 23a1 and the second base electrode 25a1 are both about 0.01 mm², the corresponding adhesive area of the electrically conductive adhesive 31 is about 0.05 mm², and the area where the electrically conductive adhesive 31 contacts the first base electrode 23a1 and the second base electrode 25a1 is about 20 %. Such first base electrode 23a1 and second base electrode 25a1 have low CI value variability and the ZCT variability becomes low.

FIGS. 3A-3B show a piezoelectric device 50 having the tuning-fork type crystal vibrating piece 20 attached to a package 51. FIG. 3A is a top view that a metal cap 56 is removed and FIG. 3B is a cross-sectional view taken from B-B line with the metal cap 56 is attached. The piezoelectric device 50 comprises the ceramic package 51 which is an insulating material, and the tuning-fork type crystal vibrating piece 20 is attached and sealed in vacuum inside of the package. The package 51 laminates plurality of ceramics thin boards (51a, 51b, 51c) formed by a ceramic green sheet made of kneading material of oxidized aluminum, and is a box shape having a room inside.

The package 51 (a base portion 51a) has at least an external terminal 59 formed on corners of the bottom. A connecting terminal 57 is formed at a step portion 51c and connected to the external terminal 59 through a through hole which is not illustrated. On the connecting terminal 57 and the external terminal 59, by metalizing a tungsten-based thick film past, nickel Ni and gold coat is applied. Also, a gold bump 55 is applied on the connecting terminal 57.

Then, on the connecting terminal 57, the electrically conductive adhesive 31 is applied from the needle, which is not illustrated, as it covers the gold bump 55. As mentioned above, sufficient amount of the electrically conductive adhesive 31 is applied for preventing such cantilevered tuning-fork type crystal vibrating piece 20 to come off. Then, to harden the electrically conductive adhesive 31, it is heated up to around 140C to 300C. Thus, the entire package 51 is put into a furnace at a temperature between 140C and 300C with the tuning-fork type crystal vibrating piece 20 attached by the electrically conductive adhesive 31. Then, the tuning-fork type crystal vibrating piece 20 is mounted on the package 51. If the electrically conductive adhesive 31 is ultraviolet cure adhesive, it is cured by irradiating ultraviolet with a high-pressure mercury lamp.

On a wall portion 51b, a sealing material 58 is formed and the sealing material 58 is formed by applying nickel and gold coat over tungsten metalizing. Also, on the top of the sealing material 58, a cap 56 is mounted, so the base portion 51a, wall portion 51b, sealing material 58 and cap 56 form a hollow box. If it is formed with metals such as kovar, the cap 56 is fixed to the wall portion 51b by seam welding or other manual manner.

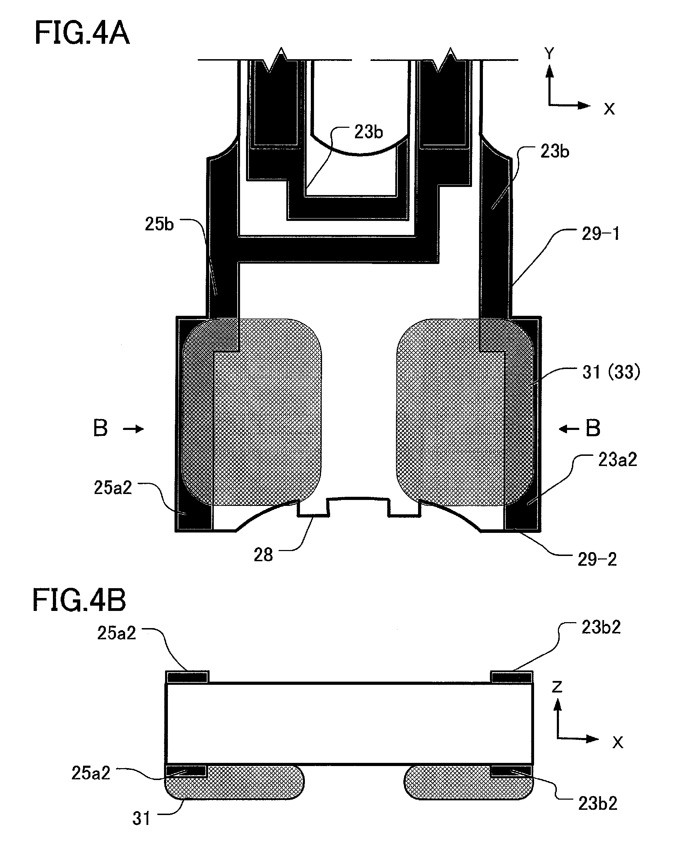

FIG. 4A is a enlarged view of the base portion 29 of the tuning-fork type crystal vibrating piece 20 of a second embodiment. FIG. 4B is a cross-sectional view taken from B-B of FIG. 4A. The first base electrode 23a2 and the second base electrode 25a2 are formed on the second base portion 29-2 formed on edge of the second base portion 29-2. The width of electrode is narrow and it is 0.01mm to 0.10mm, same as the first base electrode 23a1 and the second base electrode 25a1 of the first embodiment, and it is formed narrower than the groove electrode. In FIG. 4, the area where the electrically conductive adhesive 31 contacts to the first base electrode 23a2 and the second base electrode 25a2 is about 15 %. Such first base electrode 23a2 and second base electrode 25a2 have low CI value variability and the ZCT variability becomes low.

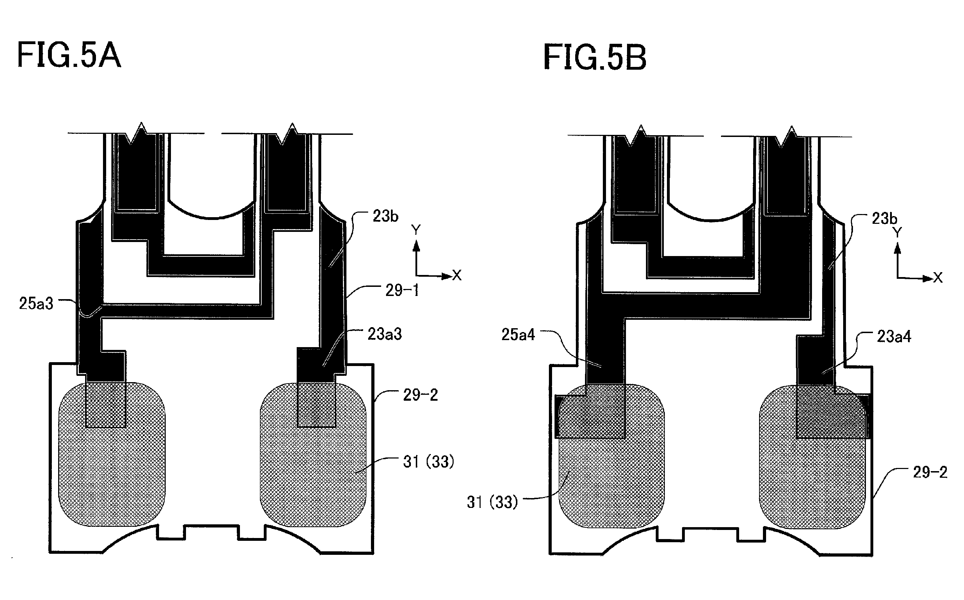

FIG. 5A is an enlarged view of the base portion 29 of the tuning-fork type crystal vibrating piece 20 of a third embodiment. FIG. 5B is an enlarged view of the base portion 29 of the tuning-fork type crystal vibrating piece 20 of a forth embodiment. The width of electrode of a first base electrode 23a3 and second base electrode 25a3 formed on the second base portion 29-2 of a third embodiment is narrow and it is 0.01mm to 0.10mm, and also formed short in Y direction. Therefore, in FIG. 5A, the area where the electrically conductive adhesive 31 contacts to the first base electrode 23a3 and the second base electrode 25a3 is about 7 %. Such first base electrode 23a3 and second base electrode 25a3 have low CI value variability and the ZCT variability becomes low.

A first base electrode 23a4 and second base electrode 25a4 formed on the second base portion 29-2 of a forth embodiment is a L-shape and the width of electrode is 0.01mm to 0.10mm. In FIG. 5B, the area where the electrically conductive adhesive 31 contacts to the first base electrode 23a4 and the second base electrode 25a4 is about 10%. Such first base electrode 23a4 and second base electrode 25a4 have low CI value variability and the ZCT variability becomes low.

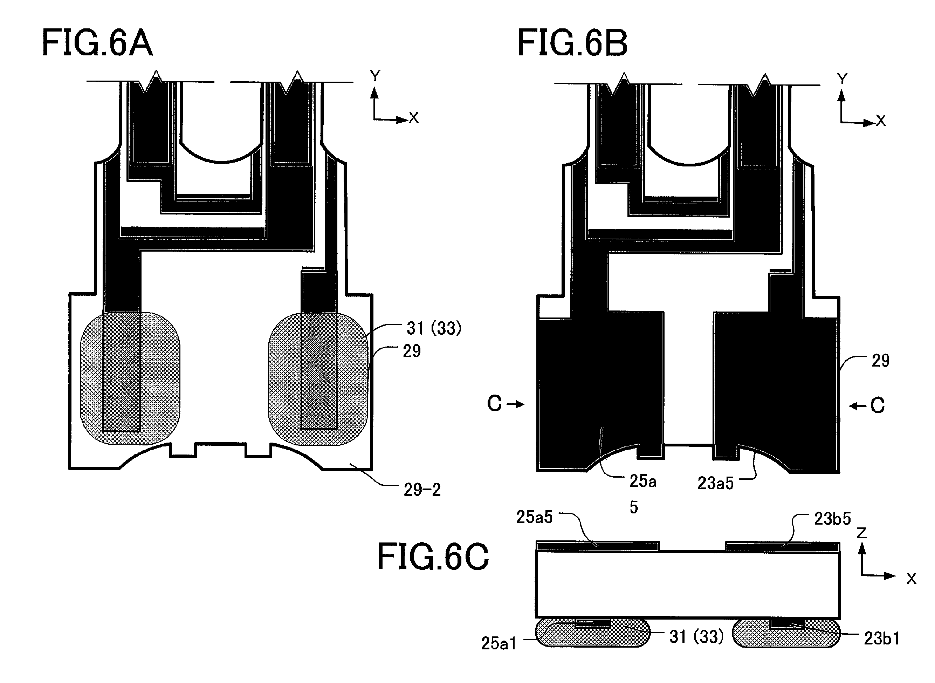

FIGS. 6A-6B are enlarged views of the second base portion 29-2 of a fifth embodiment. FIG. 6A shows a back surface (the surface to be adhered) of the second base portion 29-2, FIG. 6B is a front surface, and FIG. 6C is a cross-sectional view taken from C-C line of FIG. 6B. On the second base portion 29-2 of a sixth embodiment, the shapes of base electrodes on the front and back surface are different. As FIG. 6A shows, the first base electrode 23a1 and the second base electrode 25a1 are as same shapes as of the first embodiment. On the other hand, as FIG. 6B shows, the first base electrode 23a5 and the second base electrode 25a5 are as same shapes as of the previous base electrode. The diameter of the first base electrode 23a5 and the second base electrode 25a5 is larger than the adhesive area 33 of the electrically conductive adhesive 31. The base electrode is formed by a photolithograph step using a mask, which is not illustrated, and only for the front surface, mask can be used which is previously used.

As shown in FIG. 6C, the contact of the electrically conductive adhesive 31 and the first base electrode 23a1 and the second base electrode 25a1 is the same as the first embodiment, so the CI value variability and ZCT variability become lower.

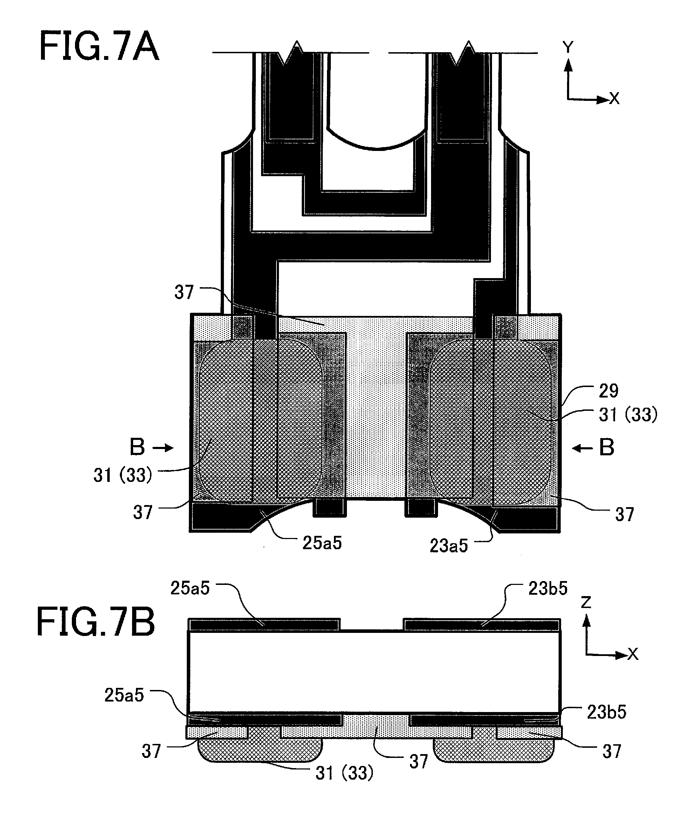

FIGS. 7A-7B are enlarged views of the second base portion 29-2 of a sixth embodiment. FIG. 7A is a back surface of the second base portion 29-2 and FIG. 7B is a cross sectional view taken from B-B line of FIG. 7A. The first base electrode 23a5 and the second base electrode 25a5 are base electrodes having large dimension as previous electrode have. If the electrically conductive adhesive 31 is applied to the electrodes with this condition, the variability of CI value and ZTC become wide. Therefore, an insulating layer 37 is coated at least on the back surface of the first base electrode 23a5 and the second base electrode 25a5 where the electrically conductive adhesive 31 is applied. The insulating layer 37 is preferably made of oxide silicone (SiO2). After the insulating layer 37 is coated, the area where the electrically conductive adhesive 31 attaching the first base electrode 23a5 and the second base electrode 25a5 becomes small. In FIGS. 7A-7B, the area where the electrically conductive adhesive 31 contacting the first base electrode 23a5 and the second base electrode 25a5 is about 15% of the adhesive area 33 of the electrically conductive adhesive 31. The sixth embodiment can make the variability of CI value and ZTC small. The shape of the insulting layer 37 can be any shape if the area the electrically conductive adhesive 31 contacting the first base electrode 23a5 and the second base electrode 25a5 is small.

### <dimension of base electrode, CI value variability and ZTC variability>

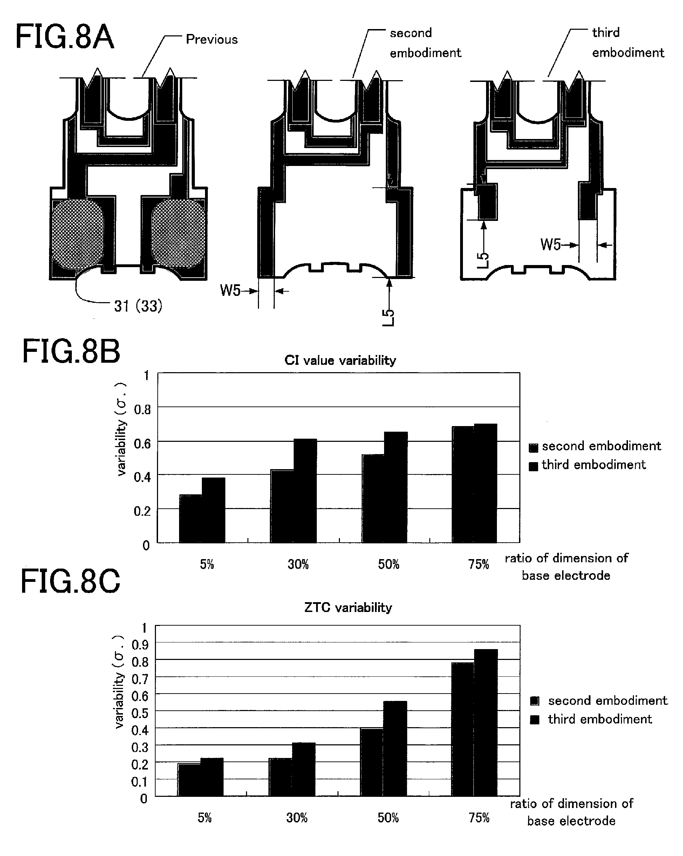

FIGS. 8A-8 pertain to research results for the tuning-fork type crystal vibrating piece 20 of the second embodiment and of the third embodiment regarding CI value and ZTC variability. The searched parameters are thirty pieces.

The figure on the left of FIG. 8A shows a previous tuning-fork type crystal vibrating piece having the base electrode 25a5 on both surfaces. The figure at the center is the tuning-fork type crystal vibrating piece of the second embodiment having the base electrode 25a2 at least on one surface and the figure on the right shows the tuning-fork type crystal vibrating piece of the second embodiment having the base electrode 25a3 at least on one surface. Note that in order to show the condition that the electrically conductive adhesive 31 is applied, the adhesive area 33 is only illustrated on the base portion of the previous tuning-fork type crystal vibrating piece, but the same amount of electrically conductive adhesive 31 is also applied to tuning-fork type crystal vibrating pieces of the second and third embodiments.

FIG. 8B is a graph showing the change of CI value of the base electrode 25a2 of the second embodiment and the base electrode 25a3 of the third embodiment. The variability (standard deviation σ) is shown on the vertical axis and dimension rate of base electrode corresponding the electrically conductive adhesive 31 on the horizontal axis. Note that by changing the length L5 and width W5 of the base electrode 25a2 or 25b3, the dimension rate of the base electrode corresponding the electrically conductive adhesive 31 is changed to 5%, 30%, 50% and 75%.

FIG. 8C is a graph showing the change of ZCT regarding the base electrode 25a2 of the second embodiment and the base electrode 25a3 of the third embodiment. The variability (standard deviation σ) is shown on the vertical axis and dimension rate of base electrode corresponding the electrically conductive adhesive 31 is shown on the horizontal axis.

The previous tuning-fork type crystal vibrating piece has the variability of CI value 2.5 and variability of ZCT is 1.3. On the other hand, the tuning-fork type crystal vibrating piece 20 of the second and third embodiment is that as the dimension ratio of the base electrode corresponding the electrically conductive adhesive 31 becomes low, the variability of CI value and variability of ZTC becomes low as well. Especially the base electrode 25a3 of the second embodiment has lower CI value variability and ZCT variability.

If the contacting area is more than 1%, the tuning-fork type crystal vibration piece 20 can be actually excited, so the minimum limit of dimension ratio of the base electrode corresponding the electrically conductive adhesive 31 is1%. On the contrary, if the dimension ratio of the base electrode corresponding the electrically conductive adhesive 31 is more than 80%, especially the variability of ZCT of the third embodiment becomes 1.0 and the difference becomes smaller compared to the previous base electrode. So, the maximum limit of dimension ratio of the base electrode corresponding the electrically conductive adhesive 31 is 80%.
As is shown by FIG. 8B and 8C, 5% to 50% of the dimension ratio of the base electrode corresponding the electrically conductive adhesive 31 is preferable.

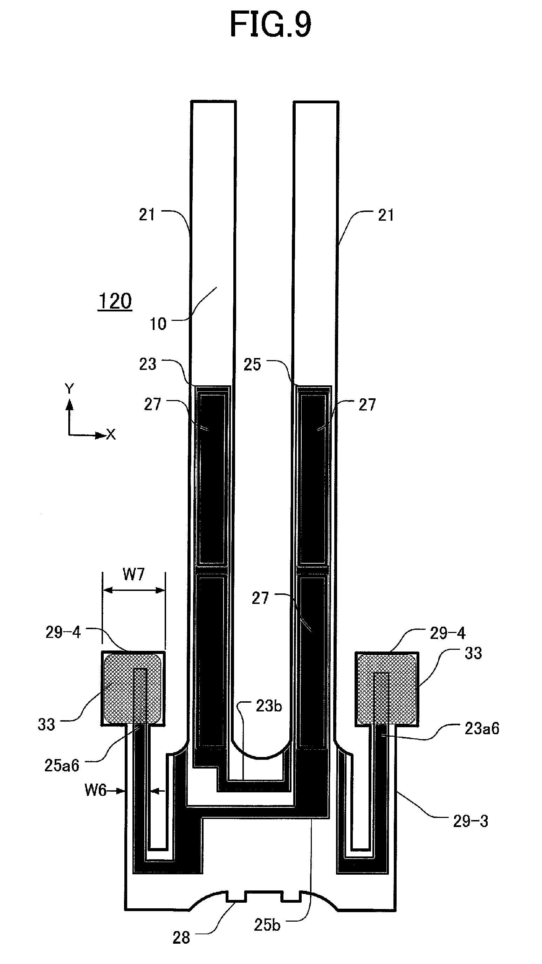

FIG. 9 is a plan view showing an embodiment of the second tuning-fork type crystal vibrating piece 120. The same components of configuration use the same numbers used in FIG. 1A and others. The second tuning-fork type crystal vibrating piece 120 has smaller base portion 29 of and the length in Y direction can be shorter than of the first tuning-fork type crystal vibrating piece 20. The second tuning-fork type crystal vibrating piece 120 is formed by cutting a single crystal wafer as it becomes crystal board 10. The second tuning-fork type crystal vibrating piece 120 comprises a pair of supporting arms 29-3. The arms 29-3 are extended in width direction of the base portion 29 from where the pair of arms 21 of the base portion 29 is formed, and in the middle of two connection portions 28, then extended parallel to the pair of vibrating arms 21 at the both of external side from where the pair of vibrating arms 21 of the base portion 29 is formed The electrode width W6 of the pair of supporting arms 29-3 is about 0.05 mm to 0.08 mm and formed narrow. At the edge of pair of supporting arm 29-3, a pair of broad areas 29-4 for conductive adhesion is formed. The electrode width W7 of the broad area 29-4 is formed 0.14 to 0.20. The outer shape of such second tuning-fork type crystal vibrating piece 120 is formed precisely by wet etching a single crystal wafer.

Even if the size of base portion 29 of the second tuning-fork type crystal vibrating piece is made small, the supporting arm 29-3 is located in designated distance from the pair of vibrating arms 21 and vibration leaked from the pair of vibrating arms 21 which does flex vibration is not affected to the broad area 29-4. To support the second tuning-fork type crystal vibrating piece 120, the illustrated adhesive area 33 is necessary.

On the base portion 29 of the second tuning-fork type crystal vibrating piece 120, a first base electrode 23a6 and a second base electrode 25a6 are formed. The first base electrode 23a6 and the second base electrode 25a6 are about 0.01mm to 0.10mm and they are formed narrowly. In FIG. 9, the area where the electrically conductive adhesive 31 contacts the first base electrode 23a6 and the second base electrode 25a6 is about 10%. Such first base electrode 23a6 and second base electrode 25a6 have low CI value variability and ZCT variability.

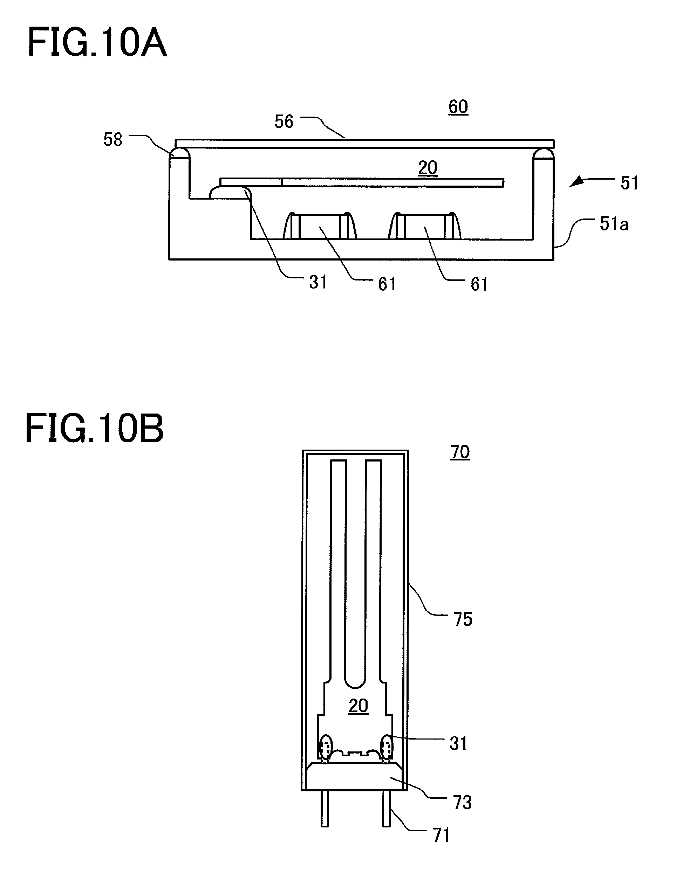

FIG. 10 A shows a tuning-fork type crystal oscillator 60. A package of tuning-fork type oscillating piece 60 uses the tuning-fork type crystal vibrating piece 20 or the second tuning-fork type crystal vibrating piece 120 of foregoing embodiments. The tuning-fork type crystal oscillator 60 has many configurations in common with the piezoelectric device 50 shown in FIGS. 3A-3B. Therefore, regarding the same configuration of the piezoelectric oscillator 50, the same numbers are assigned and their explanations are omitted. Also other piezoelectric devices are explained by using the tuning-fork type crystal vibrating piece 20.

The tuning-fork type crystal oscillator 60 shown in FIG. 10A has an arranged integrated circuit 61 over a base portion 51a at the bottom of the tuning-fork type crystal vibrating piece 20. That is, in the tuning-fork type crystal oscillator 60, when the tuning-fork type crystal vibrating piece 20 which is arranged inside vibrates, the vibration is inputted to the integrated circuit 61. By taking out the designated frequency signal, it becomes to function as an oscillator. Such integrated circuit 61 is mounted on the package 51 and then the tuning-fork type crystal vibrating piece 20 is mounted on the package 51 by the electrically conductive adhesive 31.

FIG. 10B is a schematic view of a cylinder type tuning-fork crystal oscillator 70. The cylinder type tuning-fork crystal oscillator 70 uses the above-mentioned tuning-fork type crystal vibrating piece 20. The cylinder type tuning-fork crystal oscillator 70 has a metal cap 75 to store the tuning-fork type crystal vibrating piece 20 inside. The metal cap is pressed into a stem 73 and inside of the cap is kept vacuum state. Also, two of leads 71 are arranged to hold the tuning-fork type crystal vibrating piece 20 stored in the cap 75. The lead 71 and the tuning-fork type crystal vibrating piece 20 is connected conductively by the electrically conductive adhesive 31. The tuning-fork type crystal vibrating piece 20 is vibrated when stable current is provided from the electrical portion.

The present invention is not limited to the foregoing embodiments. Each configuration of each embodiment can be combined accordingly. Also, the tuning-fork type crystal vibrating piece 20 or the second tuning-fork type crystal vibrating piece 120 comprise a pair of vibrating arms 21, but the arms can be three or more.
Moreover, foregoing embodiments shows that the dimension of the first base electrode 23a or the second base electrode 25a is smaller than the adhesive area 33 of the electrically conductive adhesive 31 to be applied to each electrode. However, when the dimension of the first base electrode 23a is bigger than the corresponding adhesive area 33, and also combined dimension of the first base electrode 23a and of the second base electrode 25a is smaller than combined dimension of two of adhesive area 33, the CI value variability and ZTC variability can be small.

## Claims

1. A piezoelectric vibrating piece comprised of a piezoelectric material having a first and second surface, comprising:
a base portion having an adhesive area of electrically conductive adhesive on the first surface for mounting;
at least a pair of vibrating arms extended in a first direction from one end of the base portion;
a base electrode arranged on the base portion; and
an exciting electrode extended in a first direction connecting the base electrode to excite the pair of vibrating arms, wherein an area of the base electrode which contacts the electrically conductive adhesive is smaller than the adhesive area.

2. The piezoelectric vibrating piece of claim 1, wherein the width of the base electrode is narrower than the width of the exciting electrode, wherein the widths are measured in a second direction that is not parallel to the first direction.

3. The piezoelectric vibrating piece of claim 1, wherein the area of the base electrode contacting the electrically conductive adhesive includes a portion extending along a direction perpendicular to the first direction.

4. The piezoelectric vibrating piece according to any of the preceding claims, wherein the dimension of the base electrode on the first surface and one on the second surface is different.

5. The piezoelectric vibrating piece according to any of the preceding claims, wherein:
the base electrode is comprised of a first base electrode and a second base electrode,
the adhesive area of the electrically conductive adhesive is comprised of a first adhesive area corresponding the first base electrode and a second adhesive area corresponding the second base electrode, and
an area of the first base electrode contacting the first adhesive area is smaller than the first adhesive area and an area of the second base electrode contacting the second adhesive area is smaller than the second adhesive area.

6. The piezoelectric vibrating piece of claim 1, wherein the base electrode area contacting the electrically conductive adhesive is defined by an insulating layer formed on the surface of the base electrode and situated between the base electrode and the adhesive area.

7. The piezoelectric vibrating piece according to any of the preceding claims, wherein the area of the base electrode contacting the electrically conductive adhesive is 1% to 80% of the adhesive area.

8. A piezoelectric device comprising:
the piezoelectric vibrating piece according to any of the preceding claims;
a package accommodating the piezoelectric vibrating piece; and
a cap sealing the package.
